**Europäisches Patentamt**

**European Patent Office**

**Office européen des brevets**

(19)

(11) Veröffentlichungsnummer: **0 163 677**

**B1**

(12)

# EUROPÄISCHE PATENTSCHRIFT

(45) Veröffentlichungstag der Patentschrift:
**12.10.88**

(21) Anmeldenummer: **84904118.1**

(22) Anmeldetag: **29.10.84**

(86) Internationale Anmeldenummer:
**PCT/EP 84/00341**

(87) Internationale Veröffentlichungsnummer:
**WO 85/01963 (09.05.85 Gazette 85/11)**

(51) Int. Cl.⁴: **C 23 C 2/16**

(54) **VORRICHTUNG ZUM VERZINNEN VON LEITERPLATTEN.**

(30) Priorität: **04.11.83 DE 3339887**

(43) Veröffentlichungstag der Anmeldung:
**11.12.85 Patentblatt 85/50**

(45) Bekanntmachung des Hinweises auf die Patenterteilung:
**12.10.88 Patentblatt 88/41**

(84) Benannte Vertragsstaaten:
**AT BE CH FR GB LI NL SE**

(56) Entgegenhaltungen:
**DE-B-1 004 256**
**FR-A-1 094 102**
**FR-A-2 287 522**
**FR-A-2 341 393**
**FR-A-2 344 641**
**GB-A-167 262**
**US-A-1 772 195**
**US-A-2 079 867**
**US-A-3 478 878**

**Patent Abstracts of Japan, Vol. 7, No. 183 (M-235)(1328), 12 August 1983**

(73) Patentinhaber: **OBERMANN, Klaus, Brüder Grimm Strasse 2d, D-6107 Reinheim 2-Ueberau (DE)**

(72) Erfinder: **OBERMANN, Klaus, Brüder Grimm Strasse 2d, D-6107 Reinheim 2-Ueberau (DE)**

(74) Vertreter: **Helber, Friedrich G., Dipl.- Ing., Patentanwälte Dipl.- Ing. F. G. Helber Dipl.- Ing. J.K. Zenz Giesser Weg 47, D-6144 Zwingenberg (DE)**

## Beschreibung

Die Erfindung betrifft eine Vorrichtung zum Verzinnen von Leiterplatten.

Die selektive Verzinnung von Leiterplatten erfolgt durch Eintauchen der entsprechend der aufzubringenden Zinnschicht maskierten Leiterplatten in ein Bad aus schmelzflüssigem Bleizinn-Lot nach vorausgehendem Eintauchen in ein Flußmittel und Vorwärmung der Leiterplatte. Die aus der Lotschmelze wieder herausgenommene Leiterplatte muß von anhaftendem überschüssigem Lot, insbesondere dem in den Löchern der Leiterplatten mitgeschleppten Lot befreit werden, wobei die schließlich verzinnten Flächenbereiche der Leiterplatte eine dünne gleichmäßige Verzinnungsschicht ohne optisch störende ungleichmäßige Strukturen an Rändern, Augen und in größeren Flächenbereichen tragen soll. Um dies zu erreichen, sind verschiedene Wege der Nachbehandlung der verzinnten Leiterplatten im Anschluß an die Entnahme der Leiterplatte aus der Lotschmelze entwickelt worden, z. B. das Aufblasen erhitzter Luft und - in neuerer Zeit - das Eintauchen in ein auf etwa 235°C erhitztes Bad aus einem wasserlöslichen Wärmeträgeröl, wobei die Leiterplatten innerhalb des Bades zwischen Schlitzdüsenrohren hindurchgeführt werden, aus denen von einer Pumpe aus dem Behälter angesaugte Wärmeträgeröl auf die Leiterplatten-Flächen aufgestrahlt und somit überschüssiges Lot - auch aus den Löchern der Leiterplatteabgestrahlt wird. Das abgestrahlte Lot sammelt sich infolge seines höheren spezifischen Gewichts am Boden des Behälters, von wo es mit einer Spezialpumpe in den Behälter mit der Lotschmelze zurückgefördert wird. Obwohl diese Verfahrensweise zu technisch einwandfreien Ergebnissen führt, kann die Oberfläche der Verzinnungsschicht Strukturverläufe des Bleizinnflusses zeigen und optisch störende Ungleichmäßigkeiten an den Rändern, Augen und auch auf größeren Flächen aufweisen, u. a. darauf zurückzuführen sein mag, daß sich beim Herausnehmen der Leiterplatten aus der Lotschmelze vor dem Einführen zwischen die Schlitzdüsenrohre infolge des möglichen Zutritts von Luft-Sauerstoff eine dünne Oxydhaut auf der Verzinnungsschicht bilden kann.

Bei einer zum kontinuierlichen Verzinnen von Draht im Durchlaufverfahren bestimmten bekannten Vorrichtung (US-Re 20 673) ist es bekannt, den Draht zunächst schräg in die Zinnschmelze einlaufen zu lassen, ihn dann um eine Rolle umzulenken und senkrecht nach oben aus der Zinnschmelze und durch ein über der Zinnschmelze lagerndes Bad eines Wärmeträgeröls zu führen, in welchem aus Strahldüsen Wärmeträgeröl auf die inzwischen verzinnte Drahtoberfläche aufgeblasen wird. Eine solche kontinuierliche Verfahrensweise ist bei der Verzinnung von steifen Leiterplatten aber nicht möglich.

Bei einer anderen bekannten Vorrichtung zur Oberflächen-Beschichtung metallischer Werkstücke in einer Schmelze des Beschichtungsmaterials (GB-A 167 262), ist über dem die Metallschmelze enthaltenden Gefäß ein Flußmittel - d. h. kein Wärmeträgeröl - vorgesehen, in welches zwei Elektroden eingetaucht sind, über welche elektrischer Strom zugeführt und so das Flußmittel und das Beschichtungsmetall aufgeschmolzen werden. Das zu beschichtende Werkstück wird zunächst durch das Flußmittel in das aufgeschmolzene Beschichtungsmetall und dann durch das Flußmittel aus dem Behandlungsbehälter zurückgeführt. Dabei hat das Flußmittel die Aufgabe, die Oxydation der Oberfläche des Werkstücks zu verhindern bzw. eventuell vorhandener Oxyde aufzulösen. Ein gerichtetes Aufblasen des Flußmittels auf die beschichtete Werkstückoberfläche erfolgt nicht.

Der Erfindung liegt die Aufgabe zugrunde, eine in ihrem Aufbau möglichst einfach ausgebildete Vorrichtung zum Verzinnen von Leiterplatten, d. h. steifen Einzelwerkstücken zu schaffen, bei welcher die Nachbehandlung der in die Lotschmelze eingetauchten Leiterplatten durch Aufstrahlen von erhitztem Wärmeträgeröl erfolgt, wobei die schließlich erhaltene Verzinnungsschicht ein einwandfreies Aussehen hat.

Diese Aufgabe wird erfindungsgemäß gelöst durch die Merkmale des Patentanspruchs 1. Das mittels des aus den Strahldüsenrohren austretenden Wärmeträgeröls von den Leiterplatten abgestrahlte überschüssige Lot wird infolge seines größeren spezifischen Gewichts sogleich und - infolge der trichterartigen schräg geneigt verlaufenden Wandabschnitte vollständig in die im unteren Behälterteil befindliche Lot-Schmelze zurückgeführt, so daß also der Einsatz einer Pumpe zum Zurückführen des Lots entfällt. Durch die im Vergleich zum oberen Behälterteil schmalere Ausführung des die Lot-Schmelze enthaltenden unteren Behälterteils kann die Lot-Füllmenge vergleichsweise gering gehalten werden, wodurch auch die zum Aufschmelzen des Lotmaterials erforderliche Energie entsprechend gering gehalten werden kann.

Die Strahldüsenrohre sind zweckmäßig zueinander höhenversetzt im oberen Behälterteil angeordnet, um durch die zeitlich versetzten Einwirkungen der Düsen-Strahlen beim Hindurchtreten der Leiterplatte zwischen den Strahldüsenrohr insbesondere das in den Löchern der Leiterplatte mitgeschleppte Lot aus den Löchern zu verdrängen.

In einer bevorzugten Weiterbildung der Erfindung sind die Strahldüsenrohre bezüglich ihres Abstandes voneinander und/oder des Düsenaustrittswinkels verstellbar im oberen Behälterteil angeordnet, um die Einwirkung der Düsenstrahlen auch unterschiedlichen Anforderungen bezüglich der Leiterplattendicke und/oder von Lot-Schmelze unterschiedlicher Zusammensetzung, anpassen zu können.

Die Strahldüsenrohre können entweder mit jeweils einer Schlitzdüse versehen sein, oder sie sind - bevorzugt mit einer Vielzahl von in Rohrlängsrichtung aufeinanderfolgend angeordneten getrennten Einzeldüsen versehen, wobei der Abstand benachbarter Düsen dann so zu wählen ist, daß sich die austretenden Strahlen des Wärmeträgeröls im Abstand der einzuführenden Leiterplatten überlappen.

Um das Auftreten unerwünschter Wirbelströmungen im Wärmeträgeröl zu vermeiden, die kleinere Teilchen des abgestrahlten Verzinnungsmaterials (Lot) im Wärmeträgeröl in der Schwebe zu halten und - im ungünstigsten Fall auf die bereits abgestrahlte Leiterplatten-Oberfläche zurückführen könnten, sind im oberen Behälterteil beidseitig des Einführweges der zu verzinnenden Leiterplatten mit parallelem Abstand voneinander senkrechte Leitbleche angeordnet.

Der Füllstand des Lots im unteren Behälterteil kann durch eine einfache Schwimmer-Einrichtung überwacht werden, wobei die genaue Füllstandshöhe beispielsweise an einem auf der Oberseite des auf dem Lot schwimmenden Schwimmers befestigten, aus dem Behandlungsbehälter herausgeführten Maßstab ablesbar ist. Eine gegebenenfalls erforderlich werdende Nachfüllung mit Lotmaterial erfolgt einfach durch Einschütten des zweckmäßig in Pulver- oder Granulatform vorliegenden Lotmaterials in den Behandlungsbehälter.

Die Saugleitung der das Wärmeträgeröl zu den Strahldüsenrohren fördernden Pumpe ist zweckmäßig an Abführkanälen angeschlossen, welche auf der Außenseite der Wandung des oberen Behälterteils angeordnet und über eine Vielzahl von Durchtrittsöffnungen mit dem Behälterinnern verbunden sind. Wenn diese Abführkanäle und die Durchtrittsöffnungen mit hinreichend großem Querschnitt bemessen sind, wird eine Verwirbelung des Wärmeträgeröls im Ansaugbereich und somit das Mitreißen von kleinsten schmelzflüssigen Lotteilchen verhindert.

Darüber hinaus kann es zweckmäßig sein, wenn in der Saugleitung zur Pumpe ein Filter und/oder ein Abscheider - beispielsweise ein Zyklon-Abscheider - für im Wärmeträgeröl mitgerissene Lotteilchen oder andere Verunreinigungen vorgesehen ist.

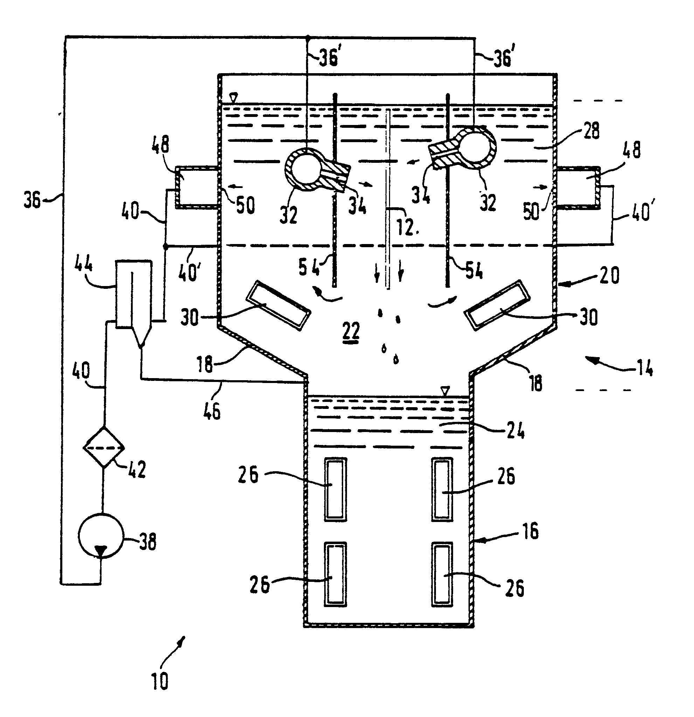

Die Erfindung ist in der folgenden Beschreibung eines Ausführungsbeispiels in Verbindung mit der Zeichnung näher erläutert, welche einen Querschnitt durch eine in der erfindungsgemäßen Weise ausgebildete Vorrichtung zum Verzinnen von Leiterplatten zeigt.

Die in der Zeichnung dargestellte, in ihrer Gesamtheit mit 10 bezeichnete erfindungsgemäße Vorrichtung zum Versinnen von Leiterplatten 12 weist einen von der Oberseite aus beschickbaren Behandlungsbehälter 14 auf, der sich aus einem schmaleren unteren Behälterteil 16 und einem über schräg geneigt verlaufende Wandabschnitte 18 aufgesetzten oberen Behälterteil 20 zusammensetzt, die einen zusammenhängenden Füllraum 22 bilden. Der untere Behälterteil 16 ist mit Bleizinn-Lot 24 als Verzinnungsmaterial gefüllt, welches über elektrische Wiederstandsheizelemente 26 auf eine Temperatur (im Bereich von 220 bis 250° C) erwärmbar ist, in welchem es schmelzflüssig ist. Durch eine nicht gezeigte Thermostatsteuerung der Heizelemente 26 wird die Temperatur der Lot-Schmelze auf der erforderlichen Höhe gehalten. Der über der Lot-Schmelze 24 verbleibende Füllraum ist weitgehend mit einem hocherhitzbaren wasserlöslichen Wärmeträgeröl 28 gefüllt, welches bei der Temperatur der Schmelze 24 noch acht siedet oder sich zersetzt und durch zweckmäßig ebenfalls durch eine - nicht gezeigte - Thermostatsteuerung in der Energieaufnahme steuerbare Widerstandsheizelemente auf eine Temperatur oberhalb der Schmelztemperatur des Verzinnungsmaterials (Lot) beheizbar ist.

Im oberen Bereich des Behälterteils 20 sind - noch unterhalb des Spiegels des Wärmeträgeröls 28 - mit Abstand voneinander und etwas höhenversetzt zwei horizontal verlaufende Strahldüsenrohre 32 angeordnet, deren entweder als Langgestreckte Schlitzdüsen oder als Reihe einer Vielzahl von in Rohrlängsrichtung aufeinanderfolgenden Einzeldüsen ausgebildete Düsen 34 aufeinander zu und leicht abwärts geneigt vom Rohrinnern in den Füllraum 22 gerichtet sind. Die Strahldüsenrohre 32 sind über Druckleitungen 36, 36' mit dem Druckanschluß einer Pumpe 38 verbunden, die saugseitig über Leitungen 40, 40' an den oberen Behälterteil 20 angeschlossen ist. In die Leitung 40 ist im gezeigten Fall noch ein Filter 42 zum Ausfiltern von Verunreinigungen und ein Abscheider 44 zum Abscheiden von im angesaugten Wärmeträgeröl gegebenenfalls noch enthaltenem Lot geschaltet, welches über eine Rückführleitung 46 vom Abscheider 44 in die Lot-Schmelze 24 zurückführbar ist.

Die Saugleitungen 40, 40' sind nicht direkt in den oberen Behälterteil 20 geführt, sondern in Abführkanäle 48, welche von auf der Außenseite des oberen Behälterteils 20 aufgeschweißten U-Profilen gebildet werden, und über eine Vielzahl von Durchtrittsöffnungen 50 in der Behälterwandung mit dem Füllraum 22 verbunden sind. Infolge ihrer Verteilung und des relativ großen Gesamtquerschnitts der Durchtrittsöffnungen 50 ist die Strömungsgeschwindigkeit in dem aus dem Behälter in die Abführkanäle übertretenden Wärmeträgeröls relativ gering und somit wirbelfrei, wodurch ein unerwünschtes Mitreißen von von der Leiterplatte 12 abgestrahlten Lotteilchen in den Pumpenkreislauf vermieden wird.

Dem gleichen Zweck dient die Anordnung von zwei beidseitig des Einführweges der zu verzinnenden Leiterplatte 12 mit parallelem Abstand voneinander angeordneten senkrechten Leitblechen 54, welche die Ausbildung einer zunächst an der zu verzinnenden Leiterplatte nach unten abgelenkten, an der Oberfläche der Lot-Schmelze 24 und den schräg geneigt verlaufenden Wandungen 18 umgelenkten und im äußeren Bereich des Behälterteils 20 in Aufwärtsrichtung zurückgeführten Kreisströmung verhindert, in welcher ebenfalls noch Lotteilchen mitgerissen werden und in die Abführkanäle 48 übertreten oder auf die bereits abgestrahlten Bereiche einer Leiterplatte 12 zurückgeführt werden könnten.

Es ist ersichtlich, daß im Rahmen des Erfindungsgedankens Abwandlungen und Weiterbildungen des beschriebenen Ausführungsbeispiel verwirklichbar sind. So können die Strahldüsenrohre 32 sowohl hinsichtlich ihres Abstandes voneinander bzw. einer durchtretenden Leiterplatte 12 als auch hinsichtlich des Düsenaustrittswinkels veränderbar ausgebildet sein. Gleiches gilt auch für die Leitbleche 54, die sowohl hinsichtlich ihres Abstandes voneinander als auch bezüglich einer von der senkrechten Lage abweichenden geneigten Lage im Behälterteil 20 veränderbar ausgebildet werden können. In jedem Falle ist es zweckmäßig, wenn die Leitbleche bis zum oder etwas über den Spiegel des Wärmeträgeröls geführt sind, um die Ausbildung einer sich über den Strahldüsenrohren 32 schließenden Kreisströmung zu verhindern.

## Patentansprüche

1. Vorrichtung zum Verzinnen von Leiterplatten durch Eintauchen in einen mit schmelzflüssigem Lot (24) gefüllten beheizbaren Behälterteil (16) mit einem weiteren beheizbaren Behälterteil (20) für ein hocherhitzbares Wärmeträgeröl (28), die einen gemeinsamen Behandlungsbehälter (14) bilden, in welchem der mit dem Wärmeträgeröl (28) gefüllte Teil (20) über dem mit schmelzflüssigem Lot (24) gefüllten Behälterteil (16) liegt, wobei im oberen Bereich des oberen Behälterteils (20) unterhalb des Spiegels des Wärmeträgeröls (28) eine Abstrahleinrichtung in Form von zwei voneinander beabstandeten Strahldüsenrohren (32) mit gegeneinander und zumindest leicht abwärts gerichteten Düsen (34) vorgesehen ist, aus denen von einer Pumpe (38) aus dem Behälter angesaugtes Wärmeträgeröl gerichtet auf die gegenüberliegenden Flachseiten der zuvor in den mit Lot gefüllten Behälterteil (16) eingetauchten Werkstücke aufstrahlbar ist, wobei der Behandlungsbehälter (14) nur an seiner Oberseite für das Eintauchen und anschließende Herausnehmen von die Werkstücke bildenden ebenflächigen Leiterplatten in senkrechter Lage offen ist, der mit Lot gefüllte untere Teil (16) des Behandlungsbehälters (14) rechtwinklig zu den Flachseiten der einzuführenden Leiterplatten (12) gesehen, senkrechte Wände aufweist und insgesamt schmaler als der mit dem Wärmeträgeröl gefüllte obere Behälterteil (20) ist, und der obere Behälterteil (20) in seinem unteren Übergangsbereich zum unteren Behälterteil (16) mit trichterartig schräg geneigt verlaufanden Wandabschnitten (18) in den schmaleren unteren Teil (16) des Behandlungsbehälters (14) übergeht.

2. Vorrichtung nach Anspruch 1, dadurch gekennzeichnet, daß die Strahldüsenrohre (32) zueinander höhenversetzt im oberen Behälterteil (20) angeordnet sind.

3. Vorrichtung nach Anspruch 1 oder 2, dadurch gekennzeichnet, daß die Strahldüsenrohre (32) bezüglich ihres Abstandes voneinander und/oder des Düsenaustrittswinkels verstellbar im oberen Behälterteil (20) angeordnet sind.

4. Vorrichtung nach einem der Ansprüche 1 bis 3, dadurch gekennzeichnet, daß die Strahldüsenrohre (32) jeweils mit wenigstens einer Schlitzdüse (34) versehen sind.

5. Vorrichtung nach einem der Ansprüche 1 bis 3, dadurch gekennzeichnet, daß die Strahldüsenrohre (32) mit einer Vielzahl von in Rohrlängsrichtung aufeinanderfolgend angeordneten getrennten Einzeldüsen (34) versehen sind, wobei der Abstand benachbarter Düsen (34) so gewählt ist, daß sich die austretenden Strahlen des Wärmeträgeröls im Abstand der einzuführenden Leiterplatten (12) überlappen.

6. Vorrichtung nach einem der Ansprüche 1 bis 5, dadurch gekennzeichnet, daß im oberen Behälterteil (20) beidseitig des Einführweges der zu verzinnenden Leiterplatten (12) mit parallelem Abstand voneinander senkrechte Leitbleche (54) angeordnet sind.

7. Vorrichtung nach einem der Ansprüche 1 bis 6, gekennzeichnet durch eine Schwimmer-Einrichtung zur Überwachung des Füllstandes des Lots (24) im unteren Behälterteil (16).

8. Vorrichtung nach einem der Ansprüche 1 bis 7, dadurch gekennzeichnet, daß die Saugleitung (40, 40') der das Wärmeträgeröl zu den Strahldüsenrohren (32) fördernden Pumpe (38) an Abführkanälen (48) angeschlossen ist, welche auf der Außenseite der Wandung des oberen Behälterteils (20) angeordnet und über eine Vielzahl von Durchtrittsöffnungen (50) mit Behälterinnern verbunden sind.

9. Vorrichtung nach Anspruch 8, dadurch gekennzeichnet, daß in der Saugleitung (40) zur Pumpe (38) ein Filter (42) und/oder Abscheider (44) für im Wärmeträgeröl mitgerissene Lotteilchen vorgesehen ist.

## Claims

1. Apparatus for the tinning of printed-circuit boards by immersion into a heatable tank part (16) filled with molten solder (24) and an additional heatable tank part (20) for a highly heatable thermofor oil (28), which together form a treatment tank (14) in which the part (20) filled with the thermofor oil (28) lies above the container part (16) filled with the molten solder, a squirting means being disposed in the upper area of the upper tank part (20) under the surface of the thermofor oil (28), in the form of two spaced-apart jet-nozzle tubes (32) with nozzles (34) directed against one another and aimed at least slightly downwardly, from which thermofor oil aspirated from the tank by a pump (38) can be squirted at the opposite flat sides of the workpieces previously immersed in the tank part (16) filled with solder, the treatment tank (14) being open only at its top for the immersion and subsequent removal of the flatsurfaced printed-circuit boards forming the workpieces in the vertical position, the solder-filled lower part (16) of the treatment tank (14), seen at right angles to the flat sides of the printed-circuit boards (12) to be introduced, has vertical walls and is narrower overall than the upper tank part (20) filled with the thermofor oil, and the upper tank part (20) merging, in its lower area of transition to the lower tank part (1, 6), with lower wall sections (18) sloping in a funnel-like manner into the narrower lower part (16) of the treatment tank (14).

2. Apparatus according to claim 1, characterized in that the jet-nozzle tubes (32) are disposed at different levels from one another in the upper tank portion (20).

3. Apparatus according to claim 1 or 2, characterized in that the jet-nozzle tubes (32) are disposed adjustably with regard to their distance apart and/or their nozzle outlet angle.

4. Apparatus according to any of claims 1 to 3, characterized in that the jet-nozzle tubes (32) are provided each with at least one slot nozzle (34).

5. Apparatus according to any of claims 1 to 3, characterized in that the jet-nozzle tubes (32) are provided with a plurality of separate individual nozzles (34) disposed successively in the tube length direction, the spacing between adjacent nozzles (34) being so selected that the emerging jets of the thermofor oil overlap one another in the spacing of the printed-circuit boards (12) that are to be introduced.

6. Apparatus according to any of claims 1 to 5, characterized in that vertical baffles (54) are disposed in the upper tank portion (20) on both sides of the path of introduction of the printed-circuit boards (12) to be tinned, at a parallel distance from one another.

7. Apparatus according to any of claims 1 to 6, characterized by a float system for controlling the level of the solder (24) in the bottom tank portion (16).

8. Apparatus according to any of claims 1 to 7, characterized in that the suction conduit (40; 40') of the pump (38) delivering the thermofor oil to the jet-nozzle tubes (32) is connected to drainways (48) which are disposed on the outside of the wall of the upper tank portion (20) and are joined to the tank interior through a plurality of openings (50).

9. Apparatus according to claim 8, characterized in that a filter (42) and/or separator (44) is provided in the suction conduit (40) of the pump (38) for solder particles entrained in the thermofor oil.

## Revendications

1. Installation d'étamage de cartes de circuits imprimés, s'effectuant par immersion dans une partie (16) d'un récipient qui peut être chauffée et qui est remplie d'étain (24) en fusion, ladite installation comportant une autre partie (20) du récipient qui peut être chauffée pour une huile caloporteur (28) chauffée à plus haute température, ces deux parties formant ensemble un récipient (14) de traitement, dans lequel la partie (20) remplie d'huile caloporteur (28), se trouve au-dessus de la partie (16) du récipient, remplie d'étain (24) en fusion, et où est prévu, dans la zone supérieure de la partie supérieure (20) du récipient, en dessous du niveau de l'huile caloporteur (28), un dispositif dissipateur thermique ayant la forme de deux lance-rayons (32), espacés l'un de l'autre, et ayant des gicleurs (34) dirigés l'un vers l'autre et au moins légèrement en aval, au moyen desquels on asperge, de façon dirigée, de l'huile caloporteur, aspirée à l'aide d'une pompe (38) en dehors du récipient sur les flancs plats opposés, des pièces à usiner qui ont auparavant été immergées dans la partie (16) du récipient remplie d'étain, et où le récipient de traitement (14) est uniquement ouvert, en position verticale, à sa surface supérieure, pour l'immersion et ensuite la sortie des pièces à usiner formées par les cartes de circuits imprimés à surface plane, la partie inférieure (16) du récipient de traitement (14), remplie d'étain, présente des parois verticales, vues en angle droit par rapport aux flancs plats des cartes (12) de circuits imprimés à introduire, et est, dans son ensemble, plus étroite que la partie supérieure (20) du récipient, remplie d'huile caloporteur, et la partie supérieure (20) du récipient passe dans la partie inférieure (16) plus étroite du récipient de traitement à l'aide de segments de paroi (18) inférieure qui se profilent en forme d'entonnoir oblique dans sa zone inférieure de transition vers la partie inférieure du récipient.

2. Installation suivant la revendication 1, caractérisée en ce que les lance-rayons (32) sont disposés, déplacés en hauteur l'un par rapport à l'autre, dans la partie supérieure (20) du récipient.

3. Installation suivant la revendication 1 ou 2, caractérisée en ce que les lance-rayons (32) sont disposés dans la partie supérieure (20) du récipient, de façon à être réglés par rapport à la distance entre eux et/ou à l'angle de sortie du gicleur.

4. Installation suivant l'une quelconque des revendications 1 à 3, caractérisée en ce que les lance-rayons (32) sont pourvus chacun d'au moins un gicleur à fente (34).

5. Installation suivant l'une quelconque des revendications 1 à 3, caractérisée en ce que les lance-rayons (32) sont pourvus de plusieurs gicleurs individuels (34) disposés à la suite l'un de l'autre dans le sens longitudinal du tube, et où la distance entre des gicleurs voisins (34) est choisie de telle sorte que les jets d'huile caloporteur qui en sortent se superposent dans la distance qui sépare les cartes de circuits imprimés à introduire.

6. Installation suivant l'une quelconque des revendications 1 à 5, caractérisée en ce que des tôles de guidage (54) verticales sont disposées, à distance parallèle l'une de l'autre, dans la partie supérieure (20) du récipient, des deux côtés de la voie d'entrée des cartes de circuits imprimés (12) à étamer.

7. Installation suivant l'une quelconque des revendications 1 à 6, caractérisée en ce qu'elle comporte un flotteur pour surveiller le niveau de remplissage de l'étain (24) dans la partie inférieure (16) du récipient.

8. Installation suivant l'une quelconque des revendications 1 à 7, caractérisée en ce que la conduite de succion (40, 40') est raccordée aux canaux d'évacuation (48) de la pompe qui aspire l'huile caloporteur vers les lance-rayons (32), lesdits canaux étant disposés sur les faces extérieures de la paroi de la partie supérieure (20) du récipient et étant reliés par plusieurs orifices (50) à l'intérieur du récipient.

9. Installation suivant la revendication 8, caractérisée en ce que dans la conduite de succion (40) vers la pompe (38), est prévu un filtre (42) et/ou un séparateur (44) pour filtrer les parties d'étain entraînées par l'huile caloporteur.